# EUROPEAN PATENT APPLICATION

(11) **EP 0 599 524 A2**
(43) Date of publication of application: **01.06.1994**
(21) Application number: 93309095.3
(22) Date of filing: 15.11.1993
(51) Int. Cl.: G11C 29/00

(54) **Self test mechanism for embedded memory arrays**

(30) Priority: 24.11.1992 US 980996
(71) Applicant: ADVANCED MICRO DEVICES, INC., Sunnyvale, CA 94088 (US)
(72) Inventor: Ganapathy, Gopi, Austin, Texas 78744 (US); Tran,Thang, Austin Texas 78730 (US)
(74) Representative: BROOKES & MARTIN

(57) **Abstract**

A method and mechanism for testing an embedded array is shown. The mechanism includes a deterministic test pattern generator which transmits test patterns to the array. The patterns are preselected based on the failure propensities of the array. The contents of the array are read and compared to the test pattern to generate a current error term. The current error term is compressed in a register through a logical operation which preserves an error indication. The contents of the register constitute a cumulative error term, and may be read to determine if an error has occurred. Each column of the tested array corresponds to a bit position in the cumulative error term, whereby a user may determine which column in the array causes an error.

## Description

The present invention relates to a mechanism and method for testing an embedded array, and more particularly to a mechanism and method for testing known error points of an embedded array with a series of predetermined test patterns.

As society's dependency on computer systems and computer-controlled devices grows, it becomes increasingly important to verify the integrity of the components which make up such systems. Microprocessors represent one family of computer components whose functioning is integral to a wide range of computer systems. Modern microprocessors typically contain a plurality of memory arrays embedded therein ("embedded arrays"). For example, reduced instruction set ("RISC") processors, the application of which has become widespread, generally possess at least two embedded memory arrays: a data cache and an instruction cache.

Various problems arise in testing embedded arrays because access to the arrays is restricted by the architecture of the microprocessor in which they are embedded. For example, it may be impossible to write some data values into the embedded arrays, which may prevent the arrays from being comprehensively tested. Further, the access restrictions imposed by the microprocessor architecture in which an array is embedded may render portions of the array virtually untestable.

Because access to an embedded array by an external testing device must be performed indirectly through the microprocessor in which the array is embedded, the computing time required to test the array is increased. For example, numerous machine instructions are typically required to indirectly write to and read values from any specific cell of an embedded array. This results in a significant increase in the computational requirements of the testing process, since testing generally requires the reading and writing of numerous values to every cell in the array. Further, the tools required for the indirect testing of embedded arrays are necessarily more. elaborate and complex than those that would be required to test readily accessible arrays.

Consequently, architectures have been developed which localize the testing hardware and provide a testing mode in which the embedded arrays are reconfigured to improve accessibility and reduce read/write overhead during testing. In the testing mode, an embedded array is tested by transmitting directly to each cell, and reading therefrom, a series of random numbers (generated by a pseudo-random number generator). After a number has been transmitted to a cell, the contents of the cell are read and compressed in a data compression register ("DCR"). The DCR compresses the values it receives by, for example, cyclic redundancy polynomial compression. When a predetermined amount of random numbers have been transmitted to and read from the embedded array, the contents ("output signature") of the DCR is read and compared with a predetermined correct signature. If the DCR output signature matches the correct signature, then the embedded array is considered to be functioning properly; otherwise, it is faulty.

One disadvantage of current random-number based testing architectures is that, while read-write overhead time has been reduced, they still require a great deal of execution time to transmit to and read from each cell enough random numbers to provide sufficient fault coverage. Since the testing patterns are random, a very large number of patterns must be used to provide an acceptable degree of fault coverage. Further still, due to the limitations of the compression techniques employed in current testing processes, it is possible for errors to cancel each other within the DCR during compression to produce a "good" signature. The process of two or more errors canceling each other to produce a correct signature is called aliasing.

Finally, testing with random patterns does not allow the targeting of specific types of memory failure. For example, in any given microprocessor manufacturing process, the occurrence of certain types of errors will be more probable than others. Consequently, certain areas within the embedded arrays formed by the process are more likely to be flawed than others. Those portions of an embedded array which exhibit relatively high failure rates are referred to herein as failure points. Random testing does not take an array's fault propensities into account. Consequently, those portions of an embedded array having extremely low failure rates are tested with the same degree of thoroughness as failure points. This results either in the insufficient testing of failure points, or in excessive (time and resource wasting) testing of low-failure-rate array portions.

It is therefore clearly desirable to provide a method and mechanism for testing an embedded array which requires less computational resources than the methods presently employed. It is further desirable to provide a method and mechanism for testing an embedded array which provides sufficient fault coverage and allows for the targeting of failure points. It is further desirable to provide a method and architecture for testing an embedded array which is not susceptible to aliasing.

In the present specification we describe a method for testing an array embedded in a microprocessor. The method includes the steps of selecting a test pattern based on a known failure point of the array, writing the test pattern into a predetermined portion of the array, reading the data contained in the predetermined portion of the array, and comparing the test pattern with the data read from the portion of the array. The method further includes the step of generating indicia of an error when the test pattern is not identical to data read from the portion of the array.

We also describe a mechanism for testing an embedded array. The mechanism comprises means for generating a test pattern based on a known failure point of the array, means for writing the test pattern into a predetermined portion of the array, means for reading the data contained in the predetermined portion of the array, and means for comparing the test pattern with the data read from the portion of the array. The mechanism further includes means for generating indicia of an error when the test pattern is not identical to data read from the portion of the array.

In addition, we describe a mechanism for testing an embedded array which includes means for generating a plurality of test patterns based on known failure points of the array, and means for successively performing the following steps: writing the test patterns into predetermined portions of the array, reading the data contained in the predetermined portion of the array, comparing the test pattern with the data read from the portion of the array, generating a current error term indicative of the comparison between the test pattern and the data read from the portion of the array, and compressing the current error term into a cumulative error term representative of previous current error terms. The mechanism further includes means for reading the cumulative error term.

We describe a mechanism for testing an embedded array which comprises an address generator coupled to the array, a compare-compress register coupled to the array, and a deterministic test pattern generator coupled to the array and to the compare-compress register. The deterministic test pattern generator transmits a series of preselected numbers to portions of the array and to the compare-compress register. The portions are determined by addresses generated by the address generator. The compare-compress register compares the values in the portions to the numbers transmitted to the portions, and generates an error term based on the comparisons.

In the accompanying drawings, by way of example only:-
Figure 1 is a block diagram illustrating the principle components of an embedded array testing mechanism embodying the present invention;
Figure 2 is a schematic block diagram illustrating the compare-compress register of Figure 1 according to one embodiment of the present invention; and
Figure 3 is a block diagram illustrating an embedded array testing mechanism for the parallel testing of a plurality of embedded arrays according to one embodiment of the invention.

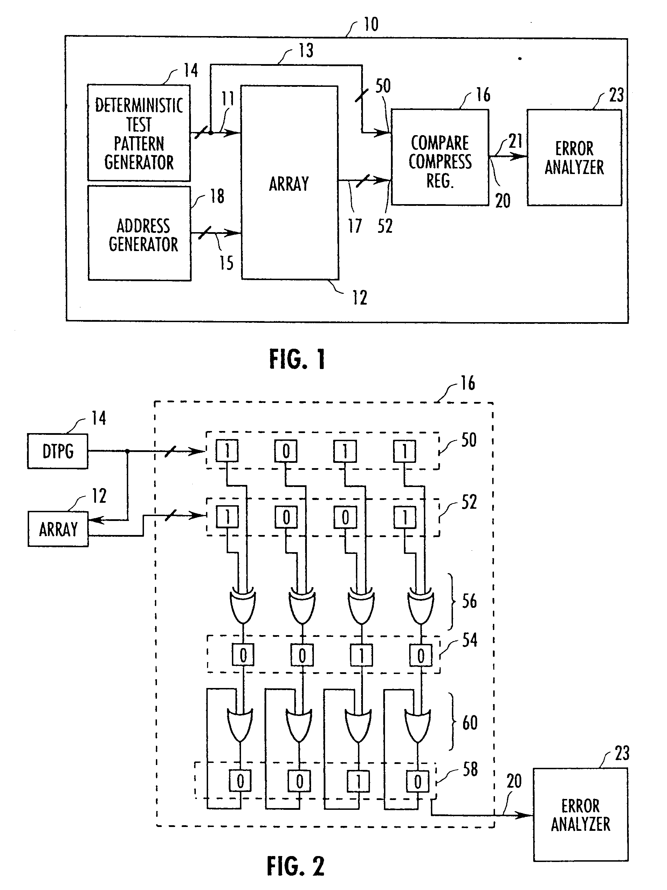

Referring to Figure 1, a microprocessor 10 is shown according to one embodiment of the present invention. The microprocessor 10 includes an embedded array 12, a deterministic test pattern generator 14, a data compare-compress register 16, and an address generator 18. The deterministic test pattern generator 14 is coupled to the array 12 by a multiple-bit line 11, and to the data compare-compress register 16 by a multiple-bit line 13. Address generator 18 is coupled to array 12 by a multiple-bit line 15. Compare-compress register 16 is also coupled to array 12 by a multiple-bit line 17, and to an error analyzer 23 via a line 21.

To test array 12, deterministic test pattern generator 14 successively generates data patterns from a set of preselected data patterns and conveys the generated data patterns to array 12 via line 11 and to compare-compress register 16 via line 13. The data patterns are preselected to target specific high-probability faults within array 12. The specific portions of array 12 which will receive the data patterns generated by deterministic test pattern generator 14 on a given test cycle are determined by the address generated by address generator 18 on that cycle.

For the purposes of the following description, it is assumed that, during each test cycle, a data pattern generated by test pattern generator 14 is transmitted to one row of cells in array 12. However, the data pattern may alternatively be transmitted in parallel to cells in array 12 grouped in other types of arrangements. For example, during each test cycle, the data pattern may be transmitted to one line of one set of cells, or to one line of four distinct sets of cells.

Address generator 18 generates addresses in a preselected sequence to target specific conditions under which embedded array 12 has a relatively high likelihood of failure. The likelihood of particular types and conditions of failure is determined based on historical error information and known qualities of the particular manufacturing process of microprocessor 10.

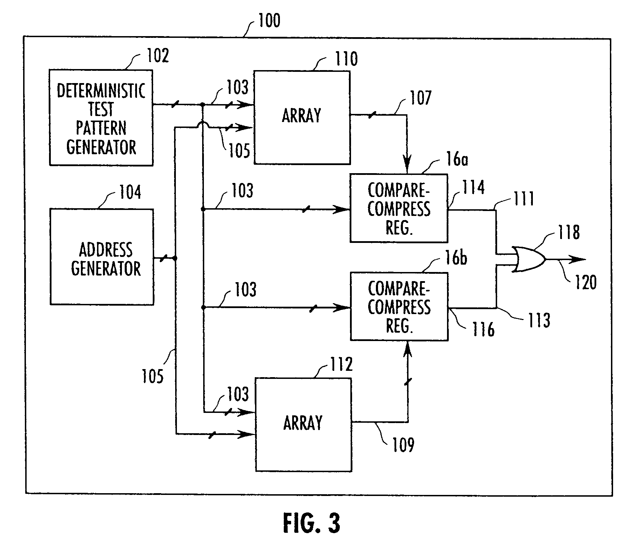

During each test cycle, deterministic test pattern generator 14 generates a test pattern and address generator 18 generates an address. The test pattern is transmitted from deterministic test pattern generator 14 over line 11 to the row of array 12 which corresponds to the address generated by address generator 18 and conveyed to array 12 over line 15. The test pattern is also transmitted directly from the deterministic test pattern generator 14 to compare-compress register 16 over line 13. The contents of the row into which the pattern was stored (the "tested row contents") are then read from array 12 and transmitted to data compare-compress register 16 over line 17. Data compare-compress register 16 compares the test pattern with the tested row contents and generates a current error term. Within compare-compress register 16, the current error term is compressed with a cumulative error term representative of previous error terms. When the set of test patterns has been generated to all of the error points, the cumulative error term is read at a port 20 over line 21 by error analyzer 23 to determine if any error occurred during the testing. Compare-compress register 16 will now be described in greater detail with reference to Figure 2.

Figure 2 shows compare-compress register 16 according to one embodiment of the invention. Compare-compress register 16 receives a test pattern of, for example, 1011, at inputs 50 from deterministic test pattern generator 14 and a tested row contents of, for example 1001, at inputs 52 from array 12 and performs a bit-wise comparison between them to generate a current error term of 0010 for this example at outputs 54. The current error term generated at outputs 54 comprises the results of each bit comparison. For example, when the comparison is made with a plurality of XOR gates 56, a zero represents a bit comparison in which the bits are identical, and a one represents a bit comparison in which the bits are different. Thus, if the tested row contents at inputs 52 are identical to the test pattern at inputs 50, the current error term generated at outputs 54 would be an array of zeros, signifying that the currently-tested row contained no error.

Once the current error term is determined at outputs 54, the current error term is compressed with a cumulative error term appearing at outputs 58. However, rather than perform linear feedback compression techniques employed currently in the art, which techniques can result in aliasing, each bit of the current error term is combined in a logical operation with the corresponding bit of the cumulative error term. The logical operation is selected to insure the perpetuation of an error indication in outputs 58. For example, when a one represents an error in the current error term, then a plurality of OR gates 60 are used to combine the cumulative error term with the current error term. Thus, if any given bit in the cumulative error term at outputs 58 is a one, indicative of an error in past comparisons, the bit will remain a one regardless of the value of the corresponding bit in the current error term. Likewise, if a bit of the current error term in outputs 54 is one, indicative of an error, the corresponding bit in the cumulative error term at outputs 58 will be a one after the compression regardless of the value of the bit prior to the compression.

When the testing process is completed, the cumulative error term 58 may be read at port 20 over line 21 by error analyzer 23. The cumulative error term will contain a one in every bit position in which an error occurred. Further, the position of a one within the cumulative error term will indicate a column of array 12 in which one or more errors occurred. For example, if the first bit in the cumulative error term is a one, then an error occurred in the column one cell of at least one of the rows that was tested. This information may help a user to track down the specific source and location of an error.

Deterministic testing may be used in place of the random testing procedures employed presently in the art, or may be used to supplement random testing. When used as a supplement, random testing provides at least a partial check for relatively rare errors, while deterministic testing provides a thorough check for relatively common errors. Further, the number of random test patterns used in random testing procedures may be reduced significantly when supplemented with deterministic testing, without significantly reducing the overall accuracy of the testing process.

To pinpoint an error once an error has been detected, single step testing may be used. Single step testing is performed as described above, accept that the cumulative error term is read at port 20 over line 21 by error analyzer 23 every time a test pattern is transmitted to a row of array 12. Thus, when error analyzer 23 detects an error in the cumulative error, the position of the bit indicating the error represents the column of array 12 in which the error occurred, and the address most recently generated by address generator 18 indicates the row in which the error occurred. The row and column information identify the specific array cell which produced the error.

Referring to Figure 3, a microprocessor 100 is shown according to an alternate embodiment of the present invention. Microprocessor 100 generally comprises a deterministic test pattern generator 102, an address generator 104, and two compare-compress registers 16a and 16b, disposed to simultaneously test two embedded arrays 110 and 112. The compare-compress registers 16a and 16b are preferably configured in accordance with the compare-compress register 16 described hereinbefore and illustrated in Figure 2. Arrays 110 and 112 may be, for example, a data cache and an instruction cache of a RISC microprocessor.

At each test cycle, deterministic test pattern generator 102 transmits, via a plurality of multiple-bit lines 103 a pattern from a set of preselected patterns to arrays 110 and 112, and to data compare-compress registers 16a and 16b. The test pattern is stored in the rows of array 110 and array 112 indicated by an address generated by address generator 104 and conveyed to arrays 110 and 112 over a plurality of multiple-bit lines 105. The tested row contents are read from arrays 110 and 112 and transmitted over multiple-bit lines 107 and 109 to compare-compress registers 16a and 16b, respectively. Each of compare-compress registers 16a and 16b compares the respective tested row contents with the test pattern, generates a current error term, and combines the current error term with a cumulative error term. When all of the predetermined patterns have been transmitted, the cumulative error terms of compare-compress registers 16a and 16b are conveyed through ports 114 and 116 over lines 111 and 113, respectively, and combined in an OR gate 118 to produce a combined cumulative error signal at an output 120.

While the present invention has been shown and described with reference to specific embodiments, various modifications and substitutions may be made without departing from the true scope and spirit of the invention. For example, embodiments for testing one or two arrays have been shown. However, the disclosed embodiments may be readily modified to perform deterministic testing on any number of embedded arrays. Further, for the purposes of discussion, it was assumed that a logical one is used to connote an error. However, an error may alternatively be indicated with a logical zero. When a zero is used to indicate an error, test patterns and tested row contents may be compared with XNOR gates, and combined with the cumulative error term in AND gates. In addition, in multiple-array embodiments, the cumulative error terms of the various compare-compress registers may be combined in AND gates to generate a combined cumulative error signal. It is anticipated that these and other alterations and modifications will no doubt become apparent to those skilled in the art. It is therefore intended that the following claims be interpreted as covering all such alterations and modifications as fall within the true spirit and scope of the invention.

## Claims

1. A method for testing an array embedded in a microprocessor, comprising:
selecting a test pattern based on a known failure point of the array;
causing a pattern generator embedded in the microprocessor to write the test pattern into a predetermined portion of the array;
transmitting the data contained in the predetermined portion of the array to a compare-compress register embedded in the microprocessor;
causing the compare-compress register to compare the test pattern with the data read from the portion of the array; and
causing the compare-compress register to generate indicia of an error when the test pattern is not identical to data read from the portion of the array.

2. The method of claim 1 wherein the indicia of an error is a current error term, and wherein the method further comprises the steps of:
causing the compare-compress register to compress the current error term into a cumulative error term representative of previously determined current error terms; and
reading the cumulative error term to determine whether an error has occurred.

3. The method of claim 2 wherein said predetermined portion is a row in the array, wherein said cumulative error comprises an array of bits wherein each bit of said array of bits corresponds to a column of the array, and wherein the value of each of said bits provides indicia of whether an error occurred in the column of the array corresponding thereto.

4. The method of claim 2 wherein the steps of selecting a test pattern based on a known failure point of the array, causing a pattern generator embedded in the microprocessor to write the test pattern into a predetermined portion of the array, transmitting the data contained in the predetermined portion of the array to a compare-compress register embedded in the microprocessor, causing the compare-compress register to compare the test pattern with the data read from the portion of the array, causing the compare-compress register to generate indicia of an error when the test pattern is not identical to data read from the portion of the array, and causing the compare-compress register to compress the current error term into a cumulative error term representative of previously determined current error terms, are repeated for multiple iterations prior to the step of reading the cumulative error term.

5. A mechanism for testing an array embedded in a microprocessor, comprising:
means, disposed in said microprocessor, for generating a test pattern based on a known failure point of the array;
means, disposed in said microprocessor, for writing the test pattern into a predetermined portion of the array;
means, disposed in said microprocessor, for reading the data contained in the predetermined portion of the array;
means, disposed in said microprocessor, for comparing the test pattern with the data read from the portion of the array; and
means, disposed in said microprocessor, for generating indicia of an error when the test pattern is not identical to data read from the portion of the array.

6. The mechanism of claim 5 wherein the indicia of an error is a current error term, and wherein the mechanism further comprises:
means for compressing the current error term into a cumulative error term representative of previously determined current error terms; and
means for reading the cumulative error term to determine whether an error has occurred.

7. The mechanism of claim 6 wherein said predetermined portion is a row in the array, wherein said cumulative error comprises an array of bits wherein each bit corresponds to a column of the array, and wherein the value of each of said bits provides indicia of whether an error occurred in the column of the array corresponding thereto.

8. A mechanism for testing an embedded array, comprising:
means for generating a plurality of test patterns based on known failure points of the array;
means for successively:
writing the test patterns into predetermined portions of the array and reading the data contained in the predetermined portions of the array;
comparing the test pattern with the data read from the predetermined portions of the array;
generating a current error term indicative of the comparison between the test pattern and the data read from the predetermined portions of the array; and
compressing the current error term into a cumulative error term representative of previous current error terms; and
means for reading the cumulative error term.

9. The mechanism of claim 8 wherein said predetermined portions are rows in the array, wherein said cumulative error comprises an array of bits wherein each bit of said array of bits corresponds to a column of the array, and wherein the value of each of said bits provides indicia of whether an error occurred in the column of the array corresponding thereto.

10. A mechanism for testing an embedded array, comprising:
an address generator coupled to the array;
a compare-compress register coupled to the array; and
a deterministic test pattern generator coupled to the array and to the compare-compress register;
wherein the deterministic test pattern generator transmits a series of preselected numbers to portions of the array and to the compare-compress register,
wherein said portions are determined by addresses generated by said address generator, and
wherein said compare-compress register compares the values in said portions to the numbers transmitted to said portions, and generates an error term based on said comparisons.

11. The mechanism of claim 10 wherein said predetermined portions are rows in the array, wherein said compare-compress register comprises an array of bits, wherein each bit of said array of bits corresponds to a column of the array, and wherein the value of each of said bits provides indicia of whether an error occurred in the column of the array corresponding thereto.

12. The mechanism of claim 10 wherein said address generator generates addresses in a preselected sequence based on known error points of the array.

13. The mechanism of claim 10 further comprising:
a second embedded array coupled to said deterministic test pattern generator and to said address generator, wherein the deterministic test pattern generator transmits said series of preselected numbers to said second array;
a second compare-compress register coupled to said deterministic test pattern generator and to said second embedded array, wherein the deterministic test pattern generator transmits said series of preselected numbers to said second compare-compress register, wherein said second compare-compress register compares the values in said second embedded array to said series of preselected numbers, wherein said second compare-compress register generates a second error term representative of said comparisons; and
means for compressing said error term generated by said compare-compress register with said second error term generated by said second compare-compress register.

14. The mechanism of claim 10 wherein said compare-compress register includes a plurality of gates configured to perform the logical XOR function, and a plurality of gates configured to perform the logical OR function, wherein said values in said portions and said values transmitted to said portions are applied to said plurality of gates configured to perform the logical XOR function to generate a current error term, and wherein said current error term and a cumulative error term are applied to said plurality of gates configured to perform the logical OR function to generate a revised cumulative error term.

15. The mechanism of claim 10 wherein said compare-compress register includes a plurality of gates configured to perform the logical XNOR function, and a plurality of gates configured to perform the logical AND function, wherein said values in said portions and said values transmitted to said portions are applied to said plurality of gates configured to perform the logical XNOR function to generate a current error term, and wherein said current error term and a cumulative error term are applied to said plurality of gates configured to perform the logical AND function to generate a revised cumulative error term.

16. A compare-compress register disposed in a system for testing an array, comprising:
means for receiving a first array of bits indicative of a test pattern;
means for receiving a second array of bits indicative of the contents of a portion of the array;
means for performing a bit-wise comparison between said first array of bits and said second array of bits to generate a third array of bits representative of said comparison;
a register comprising a plurality of bit positions, each of said bit positions corresponding to a column in said array; and
means for combining said third array of bits in said register with the contents of said register, whereby the value contained in each of said plurality of bit positions provides indicia of whether an error occurred in the column of said array which corresponds to said each of said plurality of bit positions.
